# EUROPEAN PATENT APPLICATION

(11) **EP 4 484 910 A1**
(43) Date of publication of application: **01.01.2025**
(21) Application number: 23306102.7
(22) Date of filing: 30.06.2023
(51) Int. Cl.: G01K 11/3206, G01R 31/08, G01R 31/58, H01B 7/32

(54) **A SYSTEM FOR MONITORING A POWER CABLE**

(71) Applicant: Nexans, 92400 Courbevoie (FR)
(72) Inventor: GASPARI, Roberto, 1182 OSLO (NO)
(74) Representative: Ipsilon

(57) **Abstract**

The present invention relates to a system (1) for monitoring a power cable (15). The system (1) comprises temperature and/or strain measuring elements (31) arranged on or within the power cable (15) at pre-defined locations distributed in a section (11) of the power cable (15). The system further comprises a computing device (17) configured to receive parameters representative of temperature and/or strain from the temperature and/or strain measuring elements (31), and to identify a location of any temperature and/or strain measuring element (31) experiencing temperature and/or strain exceeding a predetermined threshold value.

## Description

### FIELD OF THE INVENTION

The present invention relates to a system for monitoring a power cable. More specifically, the present invention relates to identifying hotspots and localized excessive mechanical constrains in an early phase for a suspended power cable.

### BACKGROUND OF THE INVENTION

Fatigue of submarine cables is a challenge in oil & gas and offshore wind applications, particularly where the cable transitions from the seabed to an offshore structure, e.g. a platform, wind turbine structure or sub-station. Often, the cable is protected from external loads and/or wear at this transition, e.g. by a cable protection system extending from the offshore structure to a point on the seabed or into a trench. The cable, with or without cable protection, is typically exposed to wave and current loads that induce variations in cable tension and curvature. In some instances, the offshore structure itself can induce such tension and curvature variations in the cable. A result of such variations is accumulation of fatigue damage in the cable components that eventually may lead to cable failure. One of the fatigue hot spots is often at the interface between the cable and a J-tube at the offshore structure, where a centralizer is often used to centralize the cable in the J-tube to prevent excessive wear of the cable and/or the cable protection system.

According to recent statistics over 60% of faults in offshore cable installations occur in the first 40 m of the cable as measured from the suspension point of the cable.

This is caused by the higher mechanical forces and the potential presence of hotspots generated by the necessity of utilizing bend stiffeners and curvature limiters when a cable is suspended for example from an offshore facility.

Also, proximity of metallic elements, can, for AC cables, generate additional losses in the cable and in the metallic structure thus elevating the local temperature because of the additional heat sources near and in contact with the cable itself.

The same applies in case of installation in a J-Tube where additional thermal resistance limits local heat dissipation; furthermore, the presence of an interruption of the cable at the end would limit the possibility of dissipating, by axial thermal conduction, in the "upstream" direction thus exacerbating any local hot-spot.

There are known sensors that can be used for detecting impacts such as temperature and strain and which can be embedded in optical fibers and can be incorporated in cable systems. One example is Fiber Bragg Gratings.

EP3314279B1 regards using fiber optic sensors/Rayleigh scattering/Bragg gratings for detecting deformation of a power cable.

One object of the invention is to provide a system for monitoring a power cable. In particular, one object of the invention is to provide a system for monitoring a section of the power cable localized near the suspension point of the cable.

### SUMMARY OF THE INVENTION

The present invention relates to a system for monitoring a power cable, wherein the system comprises:
- temperature and/or strain measuring elements arranged on or within the power cable at pre-defined locations distributed along a section of the power cable,
- a computing device configured to receive parameters representative of temperature and/or strain from the temperature and/or strain measuring elements, and to identify a location of any temperature and/or strain measuring element experiencing temperature and/or strain exceeding a predetermined threshold value.

The power cable may be suspendable from a suspension point. The section in which the temperature and/or strain measuring elements may be arranged, may extend from the suspension point to at least a point less than 60 meters from the suspension point.

The suspension point may be a point provided on an installation to which the cable is mechanically received and connected. Typically, the suspension point is located at a height above ground, at a height above sea level and/or at a height above the seabed. The suspension point is the point at which the cable is suspended from the installation. The suspension point may be referred to as a hanging point. The installation will typically be an offshore installation.

A first end of the power cable may be suspended from the suspension point. The computing device may be connected to the first end of the cable. The computing device may also be connected to the second end of the cable. The cable may comprise communication means for providing communication with the temperature and/or strain measuring elements via one of, or both ends of, the power cable.

Such temperature/strain measuring elements allow, for example by distributed or quasi distributed measurement over the first 60 meters from the suspension point of the cable, to identify hotspots and localized excessive mechanical constrains in an early phase of their negative evolution.

The term "strain" should be understood as mechanical strain experienced by a cable, such as mechanical tension, torsion, traction, or other mechanical deformation due to impacts on the cable. Such strain causes the cable to deteriorate over time and can eventually lead to cable failure. The temperature and/or strain measuring elements may be arranged on an outer surface of the power cable.

The temperature and/or strain measuring elements comprise:
- a flexible rod with an embedded optical fiber; and/or
- a metallic or dielectric element may comprise strain sensors.

At least some of the temperature and/or strain measuring elements may comprise fiber Bragg gratings.

The computing device may for example use distributed sensing technique, for example Rayleigh scatter based distributed fiber optic sensing for measuring temperature and/or strain using Fiber Bragg Gratings. This is done by sending a coherent laser pulse along an optical fiber, where the scattering sites of the Bragg Gratings within the fiber cause the fiber to act as a distributed interferometer with a gauge length approximately equal to the pulse length. The intensity of the reflected light is measured as a function of time after transmission of the laser pulse. When the pulse has had time to travel the full length of the fiber and back, the next laser pulse can be sent along the fiber. Changes in the reflected intensity of successive pulses from the same region of fiber are caused by changes in the optical path length of that section of fiber. This type of system is very sensitive to both strain and temperature variations of the fiber and measurements can be made almost simultaneously at all sections of the fiber.

The predetermined threshold value is a value which is determined by a user when the system is to be used to monitor a particular power cable. The predetermined threshold value can be determined depending on the characteristics of the power cable, such as material or electric configuration of the power cable, and depending on the use of the power cable or the environment in which the cable will be installed.

The measuring elements may use loose fibers for the measurement of temperature and tight fibers for the measurement of strain and temperature combined. The two components can be separated by utilizing the independently measured temperature component.

The power cable may comprise at least one conduit arranged in a longitudinal direction of the cable, wherein the temperature and/or strain measuring elements may be arranged inside the at least one conduit.

Due to the construction of the cable, the at least one conduit may be wound helically around a central axis of the cable. Such a helix can be arranged as a unidirectional helix or an alternating one, where after a number of turns in one direction the helix is inversed and so on.

The power cable may be a three-phase power cable may comprise three phase wires, and wherein the at least one conduit may be arranged in at least one space formed between the phase wires.

In a multiphase cable, such as a three-phase cable having three conducting wires, or cables with four or five conducting wires forming phases, the at least one conduit can be arranged in the or one of the spaces that are formed between the phase wires in a three-phase cable. The conduit can for example be arranged between two adjacent phases in the cable and/or in the central space formed by the three phases along the central longitudinal axis of the cable.

Such space is then filled by any shape maintaining material to allow a rigid positioning of the element within the cable structure. This technique could successfully be utilized for retrofitting.

Two or more of the temperature and/or strain measuring elements may be arranged together on or within at least one of the pre-defined locations, whereof at least one may be a temperature measuring element, and wherein the computing device may be configured to use the parameters representative of temperature from the temperature measuring elements to isolate the parameters representative of strain from the measurement from the second or more temperature and/or strain measuring elements. In one example, there are two temperature and/or strain measuring elements arranged within one of the pre-defined locations, where the first is a temperature measuring element and the second is a combined temperature and strain measuring element. Then the parameters representative of temperature in the first temperature measuring element can be used to isolate the parameters representative of strain in the combined measurement of the combined temperature and strain measuring element. In another example, there are three temperature and/or strain measuring elements arranged within one of the pre-defined locations, where the first is a temperature measuring element and the second and third are combined temperature and strain measuring elements. Then the parameters representative of temperature in the first temperature measuring element can be used to isolate the parameters representative of strain in the combined measurements of the second and third combined temperature and strain measuring elements.

The system may comprise a gas measuring element for detecting a parameter representative of a poisonous gas and/or an inflammable gas, wherein the computing device may be configured to determine if the parameter representative of a poisonous gas may be above a predetermined threshold value, and wherein the computing device may be configured to transmit an alarm signal if the parameter representative of a poisonous gas may be above the predetermined threshold value.

The power cable may be an inter-array cable, an umbilical, or any other cable that needs to be monitored to early detect possible faults.

### SHORT DESCRIPTION OF DRAWINGS

Figure 1 illustrates a power cable running from an offshore wind power plant to a onshore receiving station.
Figure 2a, fig. 2b and fig. 2c illustrate examples of a power cable being suspended from a structure.
Figure 3 illustrates a first end of a single-phase high voltage power cable.
Figure 4 illustrates a cross section of a three-phase cable.

### DETAILED DESCRIPTION

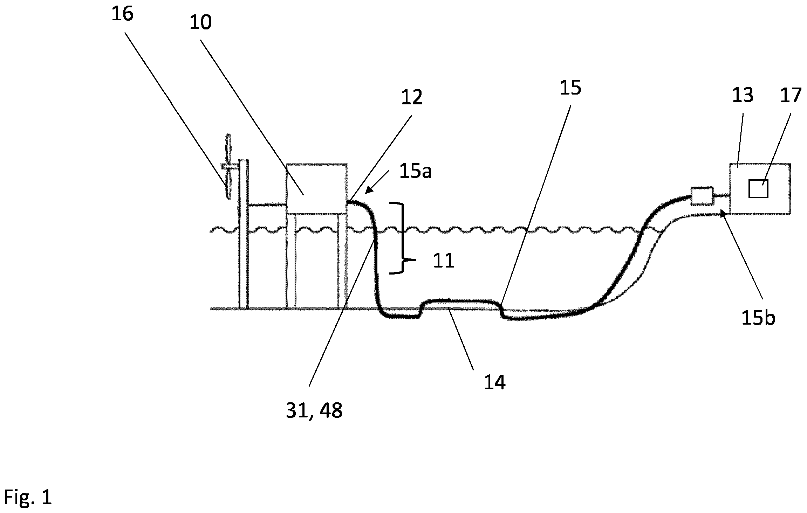

Figure 1 illustrates one example of a situation where the present invention will be applicable. A power cable 15 is here used to transfer power from an offshore wind power plant 10 having a wind turbine 16 to a receiving station 13 onshore. The power cable 15 hangs from, or is suspended from, the offshore power plant 10 at a suspension point 12, from where it has a section 11 downwards reaching towards the seabed 14. The power cable 15 then runs along on the seabed 14 and follows a gentler slope from the seabed 14 to the receiving station 13.

A first end 15a of the power cable 15 is connected to the offshore wind power plant 10, while a second end 15b of the power cable 15 is connected to the receiving station 13.

In examples such as this wind plant example, the offshore wind power plant 10 may be several kilometers or several tens of kilometers from shore. In use the conductors of the power cable 15 may carry very high voltages, of the order of hundreds of kilovolts. Thus, good quality insulation is required, and it is important that the cable is substantially defect free. Further, the use of strengthening elements surrounding the power cable 15 will prevent heat from dissipating. This may lead to hot spots that may damage the power cable 15.

Statistical surveys have shown that over 60% of faults in offshore cable installations occur in the first 40-50 m of the cable as measured from the suspension point 12 of the cable. As described above, this corresponds to the section 11 of the power cable 15. There is a need for monitoring particularly this section 11. In the present embodiment, the section 11 of the power cable 15 has a length of ca 60 m.

In fig. 1, it is further shown that the receiving station 13 comprises a computing device 17, which will be described further in detail below. It should be noted that other locations of the computing device 17 is possible.

At the suspension point 12, the power cable 15 is connected in a secured manner to ensure that the connection is not broken in rough weather conditions. This causes strain on the hanging part of the power cable 15, and even in absence of waves or dynamic loads, the cable structure at the suspension point has to support the entire weight of the cable from said suspension point 12 to either the point of contact with the seabed or to a set of load reducing floaters which are attached to the cable itself.

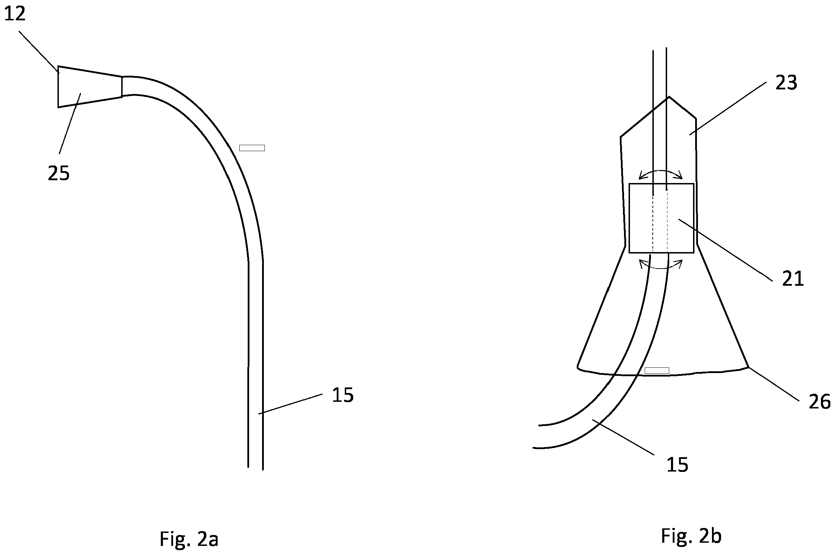

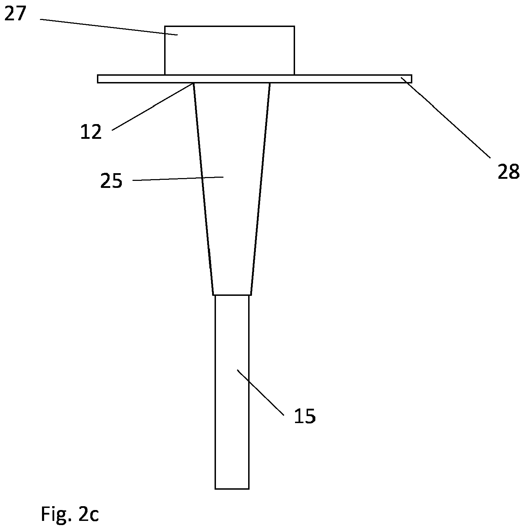

Figure 2a, 2b and 2c illustrates examples of sections 11 of a cable hanging from a structure, for example an offshore platform, wind turbine structure or sub-station, where there will be a need for a system for monitoring the power cable 15.

In figure 2a the power cable 15 hangs from a suspension point 12, through a strengthening element 25 and downwards towards for example a seabed. The strengthening element 25 distributes the load from the weight of the power cable 15 over a larger area and prevents a smaller curvature radius of the cable near the suspension point 12.

In figure 2b a centralizer/bend stiffener 21 is arranged onto a power cable 15 prior to installation. The power cable 15 with the centralizer 21 has been pulled into a J-tube 23. The centralizer 21 ensures that the power cable 15 is held along the central axis of the J-tube 23. The centralizer ensures that there is a space between the cable and the inner wall of the J-tube, and prevents the cable from touching the inside of the J-tube, thus preventing wear from friction between the cable and the J-tube. The J-tube 23 comprises a bell mouth 26 at is end portion having an expanding inner surface which allows the cable some space to avoid sharp bends at the mouth and will also let the cable deflect without touching the inner surface of the J-tube when the cable is held centrally in the tube. The J-tube 23 will typically be located at a distance below the suspension point 12. The centralizer 21 have a close fit with or is fixed to the inside of the tube 23 and have a rigidity over the length of the centralizer, thus subjecting the cable to bending movements at the transition area between the centralizer and the free parts of the cable. This can thus be a hot spot for fatigue in the cable, and the invention is aimed at detecting such hot spots before they become a problem. Figure 2c illustrates a similar situation as figure 2a, but where the power cable 15 hangs vertically from the structure, for example a platform 28. An anchoring or fixing element 27 is provided to securely connect the power cable 15 to the platform 28. The proximity of metallic elements, e.g. the platform 28, could, particularly for AC cables, generate additional losses in the cable and in the metallic structure thus elevating the local temperature because of the additional heat sources near and in contact with the cable itself.

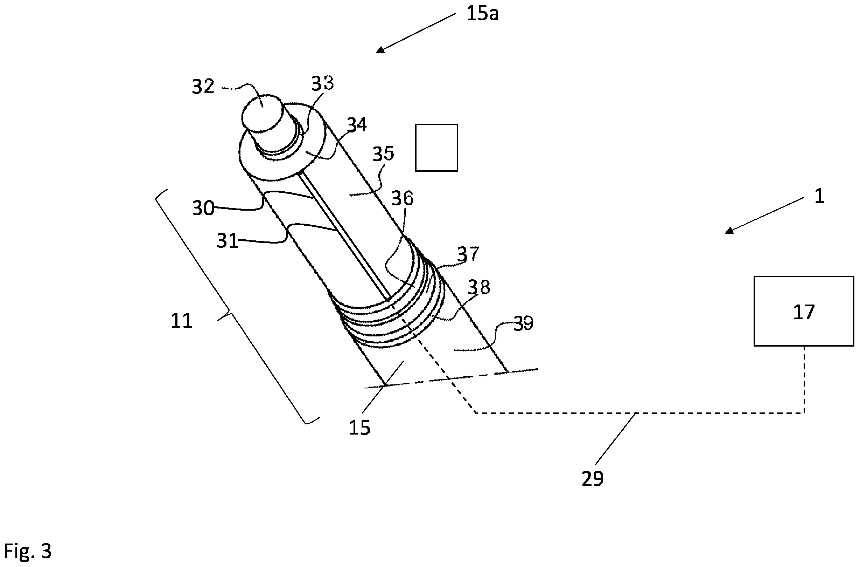

Figure 3 illustrates a system 1 for monitoring of monitoring of the power cable 15. The power cable 15 is here illustrated with its first end 15a, where an outer sheath 39, a lead sheath 38, swelling tapes 37 and an outer semiconducting screen 36 have been partially removed to show a conductor 32, an inner semiconducting screen 33 and an insulation layer 34. The system 1 comprises temperature and/or strain measuring elements 31 arranged within the section 11 of the power cable 15. In the embodiment of fig. 3, the temperature and/or strain measuring elements 31 are provided within a conduit 30 which is arranged within the power cable 15 during the manufacturing. The conduit 30 is in fig. 3 in contact with an outer surface 35 of the insulation layer 34. When the power cable 15 is in use, all layers will extend to the end 15a, so that the conduit 30 is positioned between the insulation layer 34 and the outer semiconducting screen 36.

As shown in fig. 3, the temperature and/or strain measuring elements 31 are provided in communication with the computing device 17, as illustrated by a dashed line 29.

As an alternative to the embodiment of fig. 3, the conduit 30 with the temperature and/or strain measuring elements 31 may in some embodiments be arranged helically around a central longitudinal axis of the power cable. Such a helix could be a unidirectional helix or an alternating one (a so called S/Z helix), where after a number of turns in one direction the sense is inversed and so on.

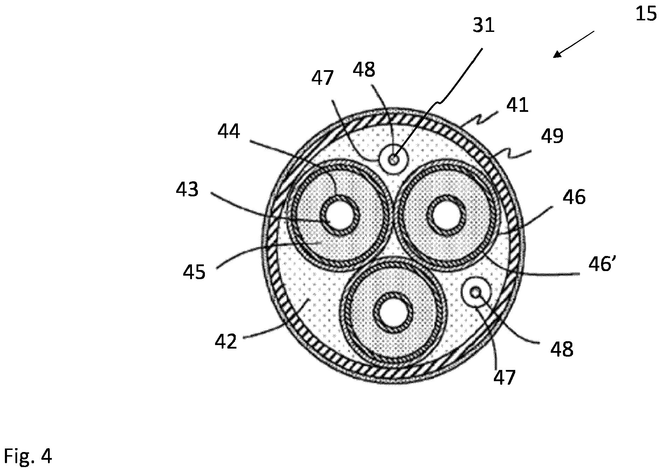

Figure 4 shows an alternative location of the temperature and/or strain measuring elements. Here, the power cable 15 is a three-phase power cable with three conductors 43, one for each AC phase. The conductors 43 are each sheathed by a layer 44 which is surrounded by a respective insulator 45 such as for example crosslinked polyethylene. Each insulator 45 may be surrounded by one or more sheathing layers 46, 46'. The sheathing layers, 46, 46', are arranged to provide electric shielding to shield the other conductors and the environment from any electric field generated by the current flowing in the conductors in use.

The three conductors, with their associated sheathing and insulation layers, are all contained within an armor layer 49 which may for instance comprise a braiding of galvanized steel wires to provide protection for the power cable. The power cable may also have an outer jacket 41.

Within the cable 15, there may be filler material 42, which may comprise a plurality of elongate filler elements or other suitable filler material disposed inside the armor 49. This can give the overall power cable a desired form and ensure the sheathed conductors are held in place within the power cable, as well as providing additional padding/protection.

Additionally, the power cable 15 may comprise at least one optical fiber within the cable, or at least comprise the ability for optical fibers to be located within the power cable, for instance to allow for data communication between the various power stations linked by the cable. For this purpose, there may be at least one fiber optic conduit 47 for carrying one or more optical fibers 48, and typically a bundle of optical fibers. The illustrated example comprises two fiber conduits 47.

The temperature and/or strain measuring elements 31 may be located within the same or corresponding locations as the illustrated fiber optic conduits 47. For example, temperature and/or strain measuring elements 31 may be arranged between two adjacent phases, and/or the sensor elements may be arranged among the phases, such as the central lobate space around the central axis of the cable.

When the temperature and/or strain measuring elements 31 is configured to measure strain in the cable, the length of the sensor element should be connected with and have the same length as the cable along the length of cable that is to be monitored by that sensor element. However, when the temperature and/or strain measuring elements 31 are configured to measure temperature, there is allowed some slack, i.e. the temperature and/or strain measuring elements 31 may be more loosely arranged along the cable length.

The temperature and/or strain measuring elements 31 may comprise a flexible rod with an embedded optical fiber. This flexible rod with embedded optical fiber may measure both temperature and strain. The strain measuring element may comprise a metallic or dielectric element comprising strain sensors. Other types of measuring elements for measuring either temperature or strain, or for measuring both temperature and strain, are also possible. As an example, the Fiber Bragg Gratings is a measuring element which can measure both temperature and strain.

The computing device 17 will typically be a digital signal processor or other type of signal processor which receive the signals representative of temperature and/or strain from the temperature and/or strain measuring elements 31. The computing device 17 is further configured to identify a location of any temperature and strain measuring element (31) experiencing temperature and/or strain exceeding a predetermined threshold value. If this is detected, an alarm signal may be issued. In this way, an early warning of possible faults can be achieved.

### List of reference numbers

- 1: monitoring system
- 10: offshore wind power plant
- 11: section of power cable
- 12: suspension point
- 13: receiving station
- 14: seabed
- 15: power cable
- 15a: first end
- 15b: second end
- 16: wind turbine
- 17: computing device
- 21: centralizer/bend stiffener
- 23: j-tube
- 25: strengthening element
- 26: bell mouth
- 27: fixing element
- 28: platform
- 29: communication line
- 30: conduit
- 31: temperature and/or strain measuring elements
- 32: conductor
- 33: inner semiconducting screen
- 34: insulation layer
- 35: outer surface of insulation layer
- 36: outer semiconducting screen
- 37: swelling tapes
- 38: lead sheath
- 39: outer sheath
- 40: cable
- 41: outer jacket
- 42: filler material
- 43: three conductors
- 44: layer
- 45: respective insulator
- 46: sheathing layers
- 46': sheathing layers
- 47: fiber optic conduit
- 48: optical fibers
- 49: armor layer

## Claims

1. A system (1) for monitoring a power cable (15), wherein the system (1) comprises:
- temperature and/or strain measuring elements (31) arranged on or within the power cable (15) at pre-defined locations distributed in a section (11) of the power cable (15),
- a computing device (17) configured to receive parameters representative of temperature and/or strain from the temperature and/or strain measuring elements (31), and to identify a location of any temperature and/or strain measuring element (31) experiencing temperature and/or strain exceeding a predetermined threshold value.

2. The system according to claim 1, wherein the power cable (15) is suspendable from a suspension point (12), and wherein the section (11) in which the temperature and/or strain measuring elements (31) are arranged, extends from the suspension point (12) to at least a point less than 60 meters from the suspension point (12).

3. The system according to claim 1 or 2, wherein the temperature and/or strain measuring elements (31) are arranged on an outer surface of the power cable (15).

4. The system according to one of the previous claims, wherein the temperature and/or strain measuring elements (31) comprise:
- a flexible rod with an embedded optical fiber; and/or
- a metallic or dielectric element comprising strain sensors.

5. The system according to any one of the previous claims, wherein at least some of the temperature and/or strain measuring elements (31) comprise fiber Bragg gratings.

6. The system according to one of the previous claims, wherein the power cable (15) comprises at least one conduit (30) arranged in a longitudinal direction of the cable, wherein the temperature and/or strain measuring elements (31) are arranged inside the at least one conduit (30).

7. The system according to claim 6, wherein the power cable is a three-phase power cable comprising three phase wires, and wherein the at least one conduit (30) is arranged in at least one space formed between the phase wires.

8. The system according to one of the previous claims, wherein two or more of the temperature and/or strain measuring elements (31) are arranged together on or within at least one of the pre-defined locations, whereof at least one is a temperature measuring element, and wherein the computing device (17) is configured to use the parameters representative of temperature from the temperature measuring elements to isolate the parameters representative of strain in the second and/or more temperature and/or strain measuring elements.

9. The system according to any one of the previous claims, wherein the system comprises a gas measuring element for detecting a parameter representative of a poisonous gas and/or an inflammable gas, wherein the computing device (17) is configured to determine if the parameter representative of a poisonous gas is above a predetermined threshold value, and wherein the computing device (17) is configured to transmit an alarm signal if the parameter representative of a poisonous gas is above the predetermined threshold value.
